# EUROPÄISCHE PATENTSCHRIFT

(11) **EP 1 502 123 B1**
(45) Veröffentlichungstag und Bekanntmachung des Hinweises auf die Patenterteilung: **06.12.2006**
(21) Anmeldenummer: 03725115.4
(22) Anmeldetag: 29.04.2003
(51) Int. Cl.: G01R 31/28, G01R 1/067

(54) **VORRICHTUNG UND VERFAHREN ZUM PRÜFEN VON LEITERPLATTEN, UND PRÜFSONDE FÜR DIESE VORRICHTUNG UND DIESES VERFAHREN**
DEVICE AND METHOD FOR TESTING PRINTED CIRCUIT BOARDS, AND TESTING PROBE FOR SAID DEVICE AND METHOD
PROCEDE ET DISPOSITIF POUR TESTER DES CARTES DE CIRCUITS IMPRIMES ET SONDE DE TEST ASSOCIEE

(30) Priorität: 07.05.2002 DE 10220343
(43) Veröffentlichungstag der Anmeldung: 02.02.2005
(73) Patentinhaber: atg test systems GmbH, 97877 Wertheim/Reichholzheim (DE)
(72) Erfinder: ROTHAUG, Uwe, 97828 Marktheidenfeld (DE); YUSCHUK, Oleh, 97877 Wertheim-Reicholzheim (DE)
(74) Vertreter: Ganahl, Bernhard
(86) Internationale Anmeldenummer: PCT/EP2003/004468
(87) Internationale Veröffentlichungsnummer: WO 2003/096037

(56) Entgegenhaltungen:
- EP-A- 0 962 777
- DE-A- 4 221 075
- US-A- 4 799 175
- US-A- 4 820 975
- US-A- 5 091 692
- US-A- 5 644 245

## Beschreibung

Die vorliegende Erfindung betrifft eine Vorrichtung und ein Verfahren zum Prüfen von Leiterplatten, sowie eine Prüfsonde für diese Vorrichtung und dieses Verfahren.

Prüfvorrichtungen zum Testen von Leiterplatten können grundsätzlich in zwei Gruppen eingeteilt werden, die mit Fingertestern und Paralleltestern. Die Paralleltester sind Prüfvorrichtungen, die mittels eines Adapters alle oder zumindest die meisten Leiterplattentestpunkte einer zu prüfenden Leiterplatte gleichzeitig kontaktieren. Fingertester sind Prüfvorrichtungen zum Testen von unbestückten oder bestückten Leiterplatten, die mit zwei oder mehreren Prüffingern die einzelnen Kontaktstellen sequentiell bzw. seriell abtasten. Das serielle Testen mit einem Fingertester ist prinzipbedingt langsamer als das parallele Testen mit einem Paralleltester.

Die Prüffinger sind in der Regel an einem Schlitten befestigt, welcher entlang von Traversen verfahrbar ist, wobei die Traversen wiederum auf Führungsschienen geführt und verfahrbar sind. Die Schlitten können somit an jede beliebige Stelle eines in der Regel rechteckförmigen Prüffeldes positioniert werden. Gleichermaßen gibt es Prüfvorrichtungen mit ortsfesten Traversen, an welchen Schlitten verfahrbar ausgebildet sind. An diesen Schlitten sind Prüffinger angeordnet, die eine gewisse Länge aufweisen und an einem Ende schwenkbar am Schlitten befestigt sind. Durch die Schwenkbewegung des Prüffingers kann ein gewisser Bereich quer zur Traverse abgetastet werden. Mit beiden Typen von Fingertestern können alle Leiterplattentestpunkte einer zu prüfenden Leiterplatte kontaktiert und damit getestet werden.

Ein Fingertester in der EP 0 468 153 A1 und ein Verfahren zum Prüfen von Leiterplatten mittels eines Fingertesters ist in der EP 0 853 242 A1 beschrieben.

Das wesentliche Kriterium um Fingertester am Markt erfolgreich durchsetzen zu können, ist die Geschwindigkeit, mit welcher eine zu prüfende Leiterplatte getestet werden kann. Um diese Prüfgeschwindigkeit zu beschleunigen sind bereits spezielle Prüfverfahren (z. B. EP 0 853 242 A1 bzw. die korrespondierende US 5,977,776) oder spezielle Prüfsonden (z. B. US 5,804,982 bzw. US 6,344,751) entwickelt worden. Eine solche Prüfsonde zum schnellen Kontaktieren eines Leiterplattentestpunktes einer zu testenden Leiterplatte geht aus der US 5,113,133 hervor.

Bei herkömmlichen Fingertestern werden vor dem eigentlichen Prüfen der zu prüfenden Leiterplatte zwei Kalibriervorgänge ausgeführt. Bei einem ersten Prüfvorgang werden die Prüfköpfe, die jeweils aus einem Schlitten und einem Kontaktfinger ausgebildet sind, bezüglich der Prüfvorrichtung kalibriert und in einem zweiten Kalibriervorgang werden die CAD-Daten einer zu testenden Leiterplatte in Übereinstimmung mit einer tatsächlichen Leiterplatte, die in die Prüfvorrichtung eingelegt ist, gebracht (z.B. DE 42 21 075 A1).

Beim ersten Kalibriervorgang wird in die Prüfvorrichtung eine Kalibrierplatte eingelegt, die eine großflächige Leiterplatte ist, auf welcher mittels der Leiterbahnen ein Gitter auf der Oberfläche der Leiterplatte ausgebildet ist. Die einzelnen Leiterbahnen sind mit einem Abstand von zum Beispiel 1 - 3 cm zueinander angeordnet. Allein im Randbereich dieser Kalibrierplatte ist eine sehr breite Leiterbahn ausgebildet, die mit allen übrigen Leiterbahnen in elektrischem Kontakt steht. Beim Kalibriervorgang wird einer der Prüffinger auf die breite Leiterbahn gesetzt und mit einem weiteren Prüffinger werden die Kreuzungspunkte des Gitters abgetastet. Wenn ein Kreuzungspunkt des Gitters getroffen ist, werden die Koordinaten des Prüffingers bzw. des Schlittens gespeichert und mit den Koordinaten des entsprechenden Kreuzungspunktes der Kalibrierplatte in Korrelation gesetz (z.B. US 48 20 975). Das Auffinden der einzelnen Kreuzungspunkte erfolgt durch ein schrittweises Annähern an den Kreuzungspunkt, bis über die beiden Kontaktfinger und die Leiterbahnen der Kalibrierplatte eine leitende Verbindung hergestellt ist. Dieses schrittförmige Annähern kann bspw. kreis- oder spiralförmig ausgeführt werden. Hierbei wird für jede Probemessung der Prüffinger auf die Kalibrierplatte abgesenkt und danach wieder angehoben. Zum Auffinden eines Gitterpunktes können einige zehn Probemessungen notwendig sein. Sind alle Gitterpunkte der Kalibrierplatte erfolgreich detektiert worden, so werden für einzelne Bereiche des Prüfbereiches unterschiedliche Korrekturwerte zum Ansteuern der Prüffinger der Prüfvorrichtung ermittelt und abgespeichert. Diese Korrektur- bzw. Kalibrierwerte erlauben, dass ein Prüffinger in einem Koordinatensystem der Prüfrichtung exakt angesteuert und im Prüfbereich plaziert werden kann.

Der zweite Kalibriervorgang wird in der Regel für jede zu prüfende Leiterplatte ausgeführt. Hierbei wird die Leiterplatte der Charge in die Prüfvorrichtung eingelegt und dann werden mittels der Prüffinger markante Leiterplattentestpunkte des Musters der zu testenden Leiterplattentestpunkte detektiert und deren Lage in der Prüfvorrichtung bestimmt. Sind die Leiterplattentestpunkte erfasst, so können die CAD-Daten der Leiterplattentestpunkte der zu testenden Leiterplatte in Übereinstimmung mit den Koordinaten der physikalischen Leiterplatte gebracht werden, d.h., dass die für eine Charge typischen Verzüge und Versätze des Musters der Leiterplattentestpunkte erfasst abgespeichert werden.

Sind beide Kalibriervorgänge durchgeführt, so können die Leiterplattentestpunkte der zu testenden Leiterplatte erfolgreich angesteuert und mittels der Prüffinger kontaktiert werden.

Der erste Kalibriervorgang ist jedes mal notwendig, wenn die Prüfvorrichtung neu eingerichtet wird, z. B., wenn ein Prüffinger ausgetauscht wird oder wenn die Prüfvorrichtung zu Beginn eines Arbeitstages neu gestaltet wird. Der erste Kalibriervorgang wird auch jedes Mal durchgeführt, wenn sich die Umgebungstemperatur um bspw. mehr als 3° C ändert.

Beide Kalibriervorgänge dauern eine beträchtliche Zeit, die nicht zum eigentlichen Prüfen der Leiterplatten genutzt werden kann. Diese Kalibriervorgänge beeinträchtigen somit den Durchsatz an Leiterplatten beim Testen derselben erheblich.

Aus der WO 92/11541 geht ein Bildgewinnungssystem für eine Vorrichtung zum Testen von Leiterplatten hervor. Dieses Bildgewinnungssystem weist ähnlich wie bei einem X-Y-Schreiber eine verfahrbare Traverse auf, auf welcher ein Prüfkopf mit einer vertikal beweglichen Prüfnadel angeordnet ist. Neben der Prüfnadel ist eine Bildgewinnungseinrichtung bestehend aus einer Linse und einem CCD-Element angeordnet. Das von der Bildgewinnungseinrichtung erzeugte Bild wird auf einem Monitor dargestellt. Ein Bediener kann anhand des am Bildschirm dargestellten Bildes den Prüfkopf derart steuert, dass er während einer Lernphase alle zu testenden Kontaktpunkte abfährt und die entsprechenden Koordinaten programmiert. Während des Tests fährt die Vorrichtung selbsttätig die einzelnen Kontaktpunkte ab und kontaktiert sie mit der Prüfnadel.

Der Erfindung liegt die Aufgabe zugrunde, eine Vorrichtung und ein Verfahren zum Prüfen von Leiterplatten mittels Prüffinger zu schaffen, mit welchen die Zuverlässigkeit beim Kontaktieren von Leiterplattentestpunkten bei weniger Kalibrieraufwand im Vergleich zu herkömmlichen Fingertestern gesteigert werden kann. Zudem liegt der Erfindung die Aufgabe zugrunde, eine Prüfsonde für diese Vorrichtung und dieses Verfahren bereit zu stellen.

Die Aufgabe wird durch eine Vorrichtung mit den Merkmalen des Anspruchs 1, ein Verfahren mit den Merkmalen des Anspruchs 11 und eine Prüfsonde mit den Merkmalen des Anspruchs 18 gelöst.

Erfindungsgemäß werden die Kontaktspitzen während des Prüfvorganges mittels einer optischen Detektionseinrichtung überwacht und deren Bewegung zumindest beim Anfahren eines Teils der Leiterplattentestpunkte einer zu testenden Leiterplatte mittels des von der optischen Detektionseinrichtung ermittelten Ergebnisses derart automatisch korrigiert, dass die Kontaktspitze sicher den jeweiligen Leiterplattentestpunkt kontaktiert. Hierdurch werden Leiterplattentestpunkte exakt kontaktiert, selbst, wenn die entsprechenden Positionierdaten noch nicht kalibriert oder noch nicht exakt kalibriert sind.

Aus den sich hierbei ergebenden Korrekturdaten können Kalibrierdaten berechnet werden.

Diese Kalibrierdaten ersetzen die beiden bei herkömmlichen Fingertestern üblichen Kalibriervorgänge, da sie die örtliche Relation zwischen den Kontaktspitzen der Prüffinger und den physikalischen Leiterplattentestpunkten der zu testenden Leiterplatten eindeutig festlegen.

Mit der erfindungsgemäßen Vorrichtung bzw. dem erfindungsgemäßen Verfahren wird der Kalibriervorgang zusammen mit dem eigentlichen Test- bzw. Messvorgang ausgeführt, ohne dass dieser erheblich verzögert wird. Dies stellt eine wesentliche Beschleunigung des Verfahrens zum Testen von Leiterplatten mittels eines Fingertesters dar und erhöht den Durchsatz an zu testenden Leiterplatten erheblich.

Nachfolgend wird die Erfindung anhand der Zeichnungen beispielhaft näher erläutert. In den Zeichnungen zeigen:
- Figur 1: eine erfindungsgemäße Prüfsonde mit einem Kamerachip,
- Figur 2: eine erfindungsgemäße Prüfsonde mit einem Lichtwellenleiterkabel,
- Figur 3: einen Schnitt durch ein Lichtwellenleiterkabel in schematischer Darstellung,
- Figur 4: schematisch einen Fingertester gemäß der Erfindung in einer Schnittdarstellung,
- Figur 5: schematisch die Bewegung einer Prüfsonde beim Ausführen des erfindungsgemäßen Verfahrens,
- Figur 6: das erfindungsgemäße Verfahren in einem Flussdiagramm,
- Figur 7: schematisch ein weiteres Ausführungsbeispiel einer erfindungsgemäßen Prüfvorrichtung in einer Schnittdarstellung, und
- Figur 8: einen Ausschnitt einer zu prüfenden Leiterplatte in vergrößerter Darstellung.

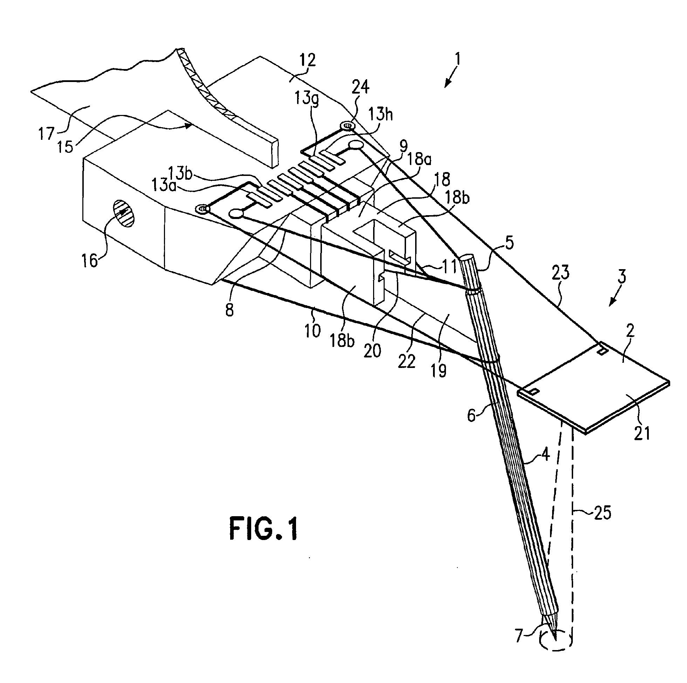

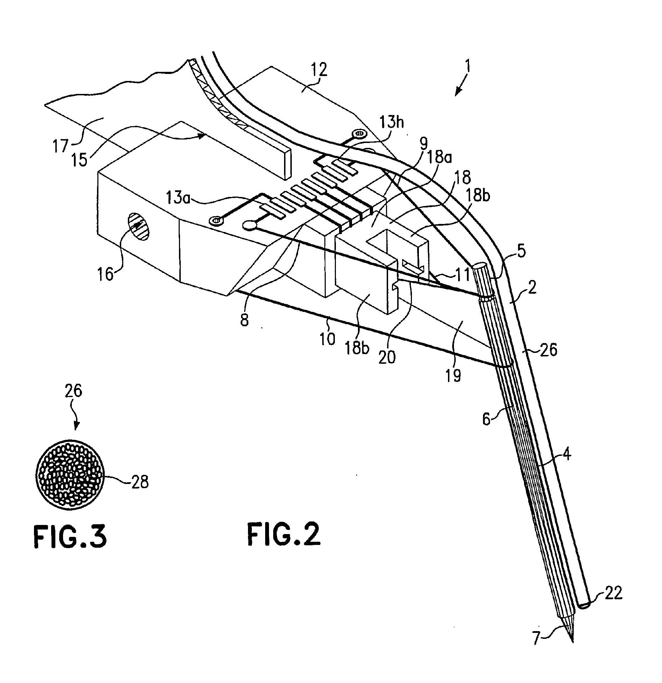

Die Figuren 1 und 2 zeigen zwei unterschiedliche Ausführungsbeispiele erfindungsgemäßer Prüfsonden 1. Diese Prüfsonden 1 weisen jeweils eine optische Empfangseinrichtung 2 einer optischen Detektionseinrichtung 3 auf. Der grundsätzliche Aufbau dieser Prüfsonde 1 mit Ausnahme der optischen Empfangseinrichtung ist in der noch nicht veröffentlichten deutschen Patentanmeldung DE 101 60 119.0 beschrieben. Auf diese Patentanmeldung wird deshalb Bezug genommen.

Die Prüfsonde 1 weist eine Prüfnadel 4 auf, die im vorliegenden Ausführungsbeispiel aus einer Nadel 5 mit einem Durchmesser d von 0,3 - 0,5 mm ausgebildet ist. Die Nadel 5 besteht z. B. aus Stahl oder Wolfram. Die Nadel 5 ist mit einer Isolationsschicht ummantelt, die zum Beispiel aus Teflon ausgebildet ist. Die Ummantelung ist wiederum mit einer elektrisch leitenden Schicht beschichtet. Diese Ummantelung mit elektrisch leitender Schicht bildet eine Abschirmung 6, die die Nadel 5 vor elektrischen Feldern abschirmt. Die Nadel 5 steht mit beiden Enden an der Abschirmung 6 vor, wobei eines der beiden Enden spitz zulaufen und zur Ausbildung einer Kontaktspitze 7 ausgebildet ist. In dem der Kontaktspitze 7 gegenüber liegenden Ende ist die Prüfnadel 4 bzw. die Nadel 5 mit zwei Haltearmen 8, 9 verbunden, die im nachfolgenden als obere Haltearme 8, 9 bezeichnet werden. Zwei weitere Haltearme 10, 11 sind ein Stück beabstandet von der Verbindungsstelle zwischen den oberen Haltearmen 8, 9 und der Prüfnadel 4 an der Abschirmung 6 befestigt. Die Haltearme 10, 11 werden als untere Haltearme 10, 11 bezeichnet. Die beiden Paar Haltearme 8, 9 bzw. 10, 11 sind jeweils aus einem Drahtstück ausgebildet, das in der Mitte abgebogen ist, wobei an der Biegestelle die Prüfnadel 4 mittels einer elektrisch leitenden Verbindung, wie zum Beispiel einer Lötverbindung, befestigt ist. Die beiden Paar Haltearme 8, 9 bzw. 10, 11 bilden somit jeweils ein gleichschenkliges Dreieck, wobei sich in der Spitze des gleichschenkligen Dreiecks die Prüfnadel 4 befindet.

Die Haltearme 9 - 11 sind mit ihren von der Prüfnadel 4 entfernten Enden an einer Halterung 12 befestigt. Die Halterung 12 ist ein elektrisch isolierendes Kunststoffteil, das an der Oberseite mit einer Reihe von Kontaktflächen 13a - 13h versehen ist. Die oberen Haltearme 8, 9 sind jeweils über Leiterbahnen mit den Kontaktflächen 13a bzw. 13h elektrisch verbunden. Die unteren Haltearme 10, 11 sind jeweils mit an der Unterseite der Halterung 12 ausgebildeten Kontaktflächen (nicht dargestellt) elektrisch verbunden.

Diese Kontaktflächen sind über weitere Leiterbahnen (nicht dargestellt) mit einer an der Halterung 12 ausgebildeten elektrischen Steckverbindung (nicht dargestellt) verbunden. Die Halterung 12 ist als Steckelement ausgebildet, das an einem Prüfkopf eines Fingertesters steckbar ist. Beim vorliegenden Ausführungsbeispiel weist die Halterung 12 einen Schlitz 15 auf, der an der von der Prüfnadel 4 entfernt angeordneten Seitenfläche der Halterung 12 mündet. Zudem weist die Halterung 12 eine Bohrung 16 auf, die quer zum Schlitz 15 angeordnet ist. Die Halterung 12 kann somit mit dem Schlitz auf eine dünne Wandung 17 des Prüfkopfes aufgeschoben und mittels eines die Bohrung 16 der Halterung und eine korrespondierende Bohrung in der Wandung 17 durchsetzenden Stiftes fixiert werden. Beim Aufschieben bzw. -stecken der Halterung 12 auf die Wandung 17 des Prüfkopfes werden gleichzeitig die mit den Kontaktflächen verbundenen Leiterbahnen mit korrespondierenden Leiterbahnen des Prüfkopfes elektrisch verbunden.

An der Halterung 12 ist an der zur Prüfnadel 4 benachbart angeordneten Seitenfläche ein Lichtschranken-Element 18 angeordnet. Das Lichtschranken-Element 18 ist in der Draufsicht U-förmig mit einer Basis 18a und zwei Schenkeln 18b ausgebildet. An einem der beiden Schenkel 18b ist innenseitig an seinem Endbereich eine Lichtquelle angeordnet und an dem anderen Schenkel 18b ist ein das Lichtsignal empfangender Lichtsensor angeordnet. Die Lichtquelle und der Lichtsensor bilden somit eine Lichtmess-Strecke. An der Prüfnadel 4 ist eine Messfahne 19 befestigt, die zum Beispiel aus einem dünnen Metallblech ausgebildet ist. Diese Messfahne liegt in einer Längsmittenebene der Prüfsonde 1, die vertikal angeordnet ist und die Spiegelebene zu den Haltearmen 8 und 9 bzw. 10 und 11 bildet. Die obere Kante der Messfahne 19 ist als Messkante 20 ausgebildet und wird bei der Bewegung der Prüfnadel 4 bezüglich der Halterung 12 in die Lichtmess-Strecke eingefahren, so dass das elektrische Mess-Signal der Lichtmess-Strecke die Position der Prüfnadel 4 bezüglich der Halterung 12 wiedergibt.

Die Prüfsonde gemäß der Figur 1 weist eine optische Empfangseinrichtung 2 in Form eines Kamerachips 21 auf, der mittels zweier Haltearme 22, 23 an der Halterung 12 an zwei Lötstellen 24 befestigt ist. Die bspw. aus Draht ausgebildeten Haltearme 22, 23 dienen als elektrische Leitungen und werden jeweils durch weitere Leitungen von der Lötstelle 24 zu den Kontaktflächen 13b bzw. 13g weiter geführt. Die Haltearme 22, 23 dienen als elektrische Zuleitungen zu dem Kamerachip 21. Diese sind hier lediglich schematisch dargestellt. Da ein Kamerachip in der Regel mehr als zwei elektrische Anschlüsse aufweist, ist es zweckmäßig, an den Haltearmen 22, 23 weitere elektrische Leitungen sowie Einzelanschlüsse vorzusehen. Der Kamerachip 21 weist an seiner zur Kontaktspitze 7 gerichteten Seite ein optisch empfindliches Sensorfeld auf, das in der Regel ein CCD-Sensor ist. An dem Sensorfeld ist eine Linse vorgesehen, so dass ein Gegenstand innerhalb eines Betrachtungskegels 25 auf das Sensorfeld optisch abgebildet wird und von dem Kamerachip in ein elektrisches Bildsignal gewandelt wird. Der Kamerachip 21 ist derart angeordnet, dass sich die Kontaktspitze 7 im Betrachtungskegel 25 befindet. Mit dem Kamerachip 21 wird somit die Kontaktspitze 7 optisch erfasst.

Ein alternatives Ausführungsbeispiel der erfindungsgemäßen Prüfsonde ist in Figur 2 gezeigt. Diese Prüfsonde entspricht im wesentlichen dem Aufbau der Prüfsonde aus Figur 1, weshalb gleiche Teile mit gleichen Bezugszeichen versehen sind. Anstelle des Kamerachips ist ein Lichtwellenleiterkabel 26 vorgesehen, das an der Prüfnadel 4 befestigt ist. Das Lichtwellenleiterkabel 26 ist mit seinem freien Ende 27, an dem eine Linse vorgesehen ist, benachbart zur Kontaktspitze 7 angeordnet. Das Lichtwellenleiterkabel 26 besteht aus vielen parallel laufenden Lichtleitfasern 28 (Figur 3). Die am Randbereich des Lichtleiterkabels 26 angeordneten Lichtleitfasern 28 sind mit ihrem von der Kontaktspitze entfernt angeordneten Ende mit einer Lichtquelle verbunden, so dass das Licht der Lichtquelle einem Bereich der Kontaktspitze 7 zugeführt wird. Mit den weiteren Lichtleitfasern 28 wird das von der Kontaktspitze 7 bzw. dem umliegenden Bereich reflektierte bzw. abgestrahlte Licht empfangen und einer Kamera (nicht dargestellt) zugeführt. Über das Lichtleiterkabel 26 kann somit auch die Kontaktspitze 7 optisch erfasst werden und ein entsprechendes Bild in Form von elektrischen Signalen erzeugt werden.

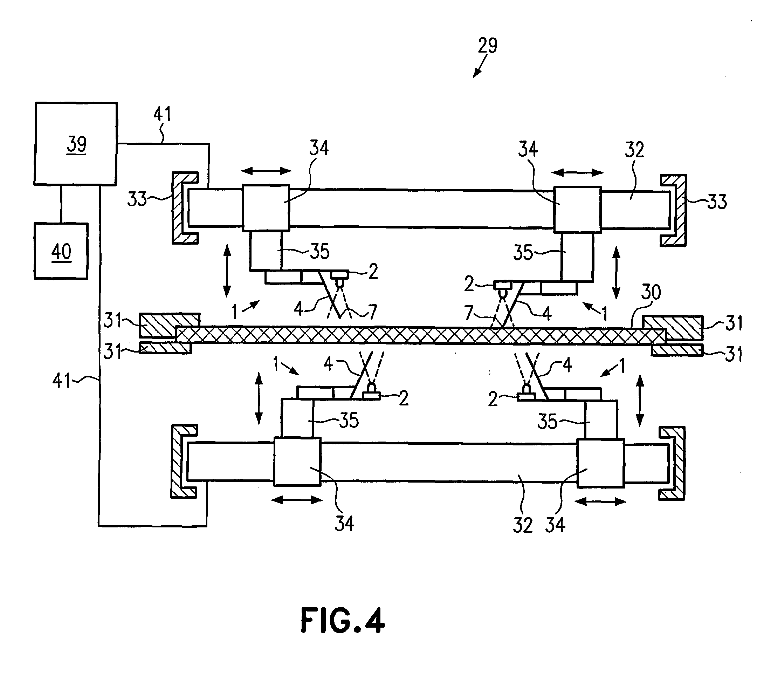

Figur 4 zeigt schematisch eine Vorrichtung 29 zum Prüfen von Leiterplatten 30. Diese Vorrichtung bzw. Prüfvorrichtung 29 ist ein Fingertester. Die zu prüfende Leiterplatte 30 wird von einem Halterahmen 31 gehalten. Dieser Halterahmen 31 begrenzt einen rechteckigen, ebenflächigen Aufnahmebereich zum Aufnehmen einer Leiterplatte. Dieser Aufnahmebereich bildet ein Prüffeld, in dem Leiterplattentestpunkte einer zu prüfenden Leiterplatte kontaktiert werden können. Im Bereich oberhalb und unterhalb des Aufnahmebereiches sind Traversen 32 angeordnet, die sich über den Aufnahmebereich hinweg erstrecken. Vorzugsweise sind oberhalb und unterhalb des Aufnahmebereiches jeweils mehrere Traversen angeordnet, die zueinander parallel ausgerichtet sind. Die Traversen 32 werden mit ihren Enden in Schienen 33 gehalten. Die Schienen 33 verlaufen senkrecht zur Zeichenebene der Figur 4, d.h. senkrecht zu den Traversen 32 bzw. parallel zur Ebene des Aufnahmebereiches. Die Traversen 32 können in den Schienen 33 verfahrbar ausgebildet sein.

An den Traversen 32 sind im vorliegenden Ausführungsbeispiel jeweils zwei Schlitten 34 angeordnet, die entlang der Traversen hin und her verfahren werden können. An den Schlitten 34 ist an der zum Aufnahmebereich zugewandten Seite jeweils ein Prüfkopf 35 angeordnet. An dem zum Aufnahmebereich weisenden Ende des Prüfkopfes 35 ist jeweils eine Prüfsonde 1 angeordnet, wie sie in Figur 1 gezeigt ist. Der Prüfkopf 35 ist am Schlitten 34 in eine Richtung senkrecht zu der zu prüfenden Leiterplatte 30 bzw. senkrecht zur Ebene des Aufnahmebereiches beweglich ausgebildet. Hierzu kann ein Linearmotor vorgesehen werden, wie er beispielsweise in der deutschen Patentanmeldung DE 101 60 119.0 beschrieben ist. Anstelle des Linearmotors kann prinzipiell auch ein anderer Stellmechanismus verwendet werden. Der Prüfkopf 35 kann auch mit einem Drehmechanismus derart versehen sein, dass die den Prüffinger darstellende Prüfsonde 1 um eine zur Leiterplatte 30 senkrecht stehende Achse geschwenkt werden kann. Bei einer solchen Ausführungsform können die Traversen 32 ortsfest angeordnet sein.

Die Prüfvorrichtung 29 weist eine Steuereinrichtung 39 auf, die mit einer kombinierten Detektions-/Auswerteeinrichtung 40 verbunden ist. Die Steuereinrichtung 39 ist mit Leitungen 41 mit den Stellgliedern (Schlitten 34, Prüfkopf 35) und den Sensoren (Kamera 2, Prüfnadel 5) der Prüfvorrichtung 29 verbunden. Die Steuereinrichtung steuert selbsttätig die Bewegung der Prüfnadel 5 zum Kontaktieren von Leiterplattentestpunkten auf der zu testenden Leiterplatte 30. Die Detektions-/Auswerteeinrichtung 40 empfängt die optischen Signale der Kameras 2 und wertet sie automatisch aus, wie es unten näher erläutert ist. Nach Maßgabe der mit der Detektions-/Auswerteeinrichtung 40 ermittelten Daten steuert die Steuereinrichtung 39 die Bewegung der Prüfnadel 5.

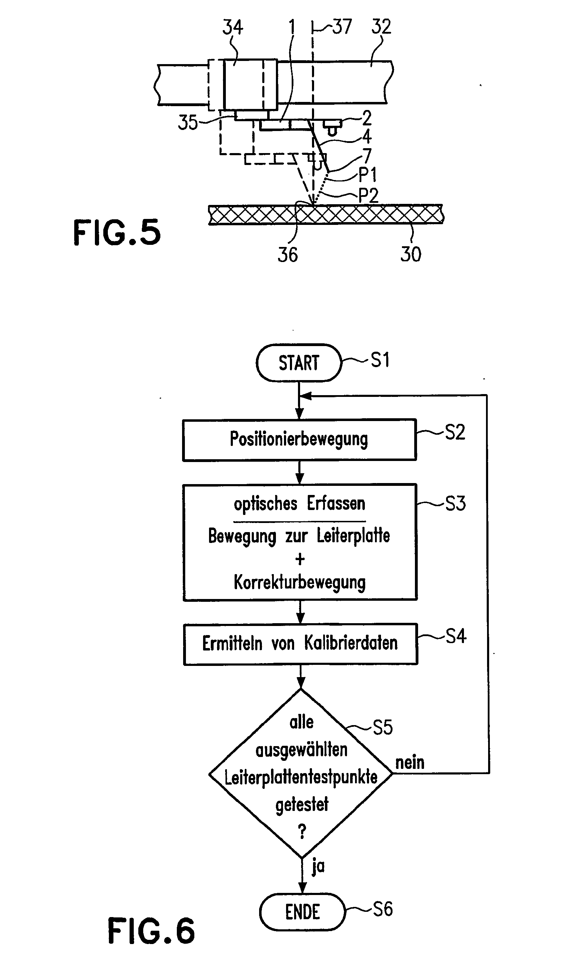

Nachfolgend wird anhand von Figur 5 und 6 die Funktionsweise der erfindungsgemäßen Vorrichtung näher erläutert. Figur 5 zeigt schematisch einen Ausschnitt der Prüfvorrichtung aus Figur 4 zusammen mit einem Ausschnitt der Leiterplatte, wobei der Prüfkopf 35 in der maximal entfernten Position zur Leiterplatte 30 (durchgestrichene Linien) und in einer Position, in der die Prüfnadel die Oberfläche der Leiterplatte berührt (gestrichelte Linie), dargestellt ist.

Das Verfahren beginnt (Schritt S1), nachdem eine Leiterplatte, insbesondere die erste Leiterplatte einer Charge von zu prüfenden Leiterplatten, in die Prüfvorrichtung eingelegt ist.

Danach wird eine Positionierbewegung (S2) ausgeführt, in der die Prüfsonde parallel zur Ebene der zu testenden Leiterplatte 30 verfahren wird, bis die Kontaktspitze 7 etwa am Bereich eines auf einen Leiterplattentestpunkt 36 stehenden Lotes 37 angeordnet ist. Wenn die Prüfvorrichtung noch nicht kalibriert ist, ergeben sich beim Ansteuern der Positionierbewegung eine entsprechend Abweichung, wie sie in Figur 5 zwischen dem Lot 37 und der Prüfspitze 7, in der mit Abstand zur Leiterplatte 30 angeordneten Stellung, der Ausgangsstellung, gezeigt ist.

Es wird dann mittels der optischen Detektionseinrichtung, d.h. mit dem Kamerachip 21 und einer entsprechenden Auswerteeinrichtung, ein Bild der Prüfspitze vor dem Hintergrund der Leiterplatte aufgenommen (S3) und anhand dieses Bildes wird der Abstand der Prüfspitze 7 vom Zentrum des Leiterplattentestpunktes 36 ermittelt. Nachfolgend wird eine Korrekturbewegung ausgeführt, um die Prüfspitze 7 näher an das Lot 37 heran zu führen. Gleichzeitig mit der Korrekturbewegung oder vorher oder nachher wird die Prüfsonde ein Stück in Richtung zur Leiterplatte 30 bewegt. Nach Ausführen dieser beiden Bewegungskomponenten befindet sich die Prüfspitze 7 ein Stück näher am Lot 37 und ein Stück näher an der zu testenden Leiterplatte 30 am Punkt P1. An diesem Punkt wird erneut die Prüfspitze mittels der optischen Detektionseinrichtung vor dem Hintergrund der zu prüfenden Leiterplatte 30 erfasst und der Abstand und die Richtung zum Zentrum des zu kontaktierenden Leiterplattentestpunktes ermittelt. Danach wird wiederum eine Korrekturbewegung und eine Bewegung in Richtung der Leiterplatte 30 ausgeführt. Die Prüfspitze 7 befindet sich nun an einem weiteren Punkt P2, der wiederum näher am Lot 37 und an der Leiterplatte 30 gegenüber dem Punkt P1 angeordnet ist. Hier wird wiederum die Prüfspitze 7 vor dem Hintergrund der zu prüfenden Leiterplatte 30 erfasst und der Abstand zum Zentrum des zu kontaktierenden Leiterplattentestpunktes 36 ermittelt. Danach wird wiederum eine Korrekturbewegung ausgeführt und die Prüfsonde auf die Leiterplatte 30 zu bewegt, bis die Prüfspitze 7 auf dem Leiterplattentestpunkt 36 aufliegt. Die Berührung einer Leiterplatte 30 mittels der Prüfspitze 7 bzw. der Prüfnadel 4 wird an der Prüfsonde 1 mittels der Messfahne 19 und dem Lichtschrankenelement 18 detektiert (Fig. 1 und 2).

Die Vektorsumme aller Korrekturbewegungen ergibt den Betrag und die Richtung der des Abstandes der Kontaktspitze 7 in ihrer Ausgangsstellung vom Lot 37. Dieser Abstandswert wird gespeichert. Aus diesen werden Kalibrierdaten berechnet (S4), die bei einer erneuten Bewegung einer Prüfsonde zu einem Leiterplattentestpunkt verwendet werden.

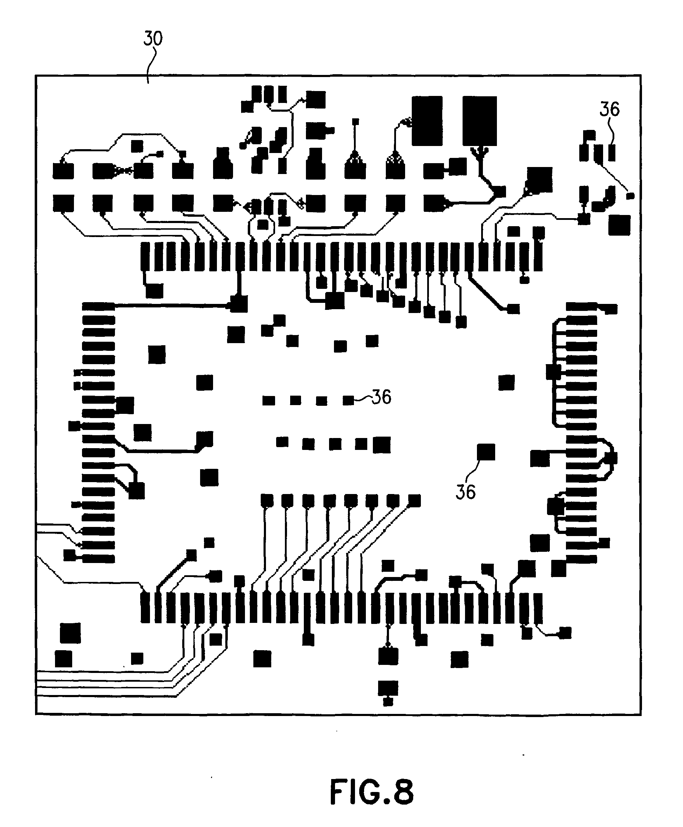

Dieses Verfahren wird für eine vorbestimmte Auswahl von Leiterplattentestpunkten 36 der zu untersuchenden Leiterplatte 30 ausgeführt. Diese Leiterplattentestpunkte 36 sind besonders unterscheidungskräftig, d.h., dass sie mit anderen Leiterplattentestpunkten nicht verwechselt werden, beim Anfahren mit der noch nicht kalibrierten Prüfvorrichtung. Einige Leiterplattentestpunkte sind zum Beispiel in einem größeren Bereich einzeln angeordnete Leiterplattentestpunkte. Als größerer Bereich wird beispielsweise ein Bereich von 1 cm² oder mehr verstanden. Weiterhin können derartige unterscheidungskräftige Leiterplattentestpunkte 36 Leiterplattentestpunkte sein, die am Rand einer Gruppe von Leiterplattentestpunkten angeordnet sind und so einfach auf dem vom Kamerachip 21 erfassten Bild identifizierbar sind (Fig. 8). Im Schritt S5 wird geprüft, ob alle ausgewählten Leiterplattentestpunkte 36 getestet sind. Wenn dies nicht der Fall ist, wird ein weiterer der ausgewählten Leiterplattentestpunkte 36 mit der Prüfsonde angefahren, wobei wiederum beim Anfahren die oben erläuterten Korrekturbewegungen ausgeführt werden, um den Leiterplattentestpunkt sicher mit der Kontaktspitze 7 zu treffen. Aus den entsprechenden Abstandswerten werden wiederum Kalibrierdaten ermittelt.

Mit dem Schritt S5 wird festgestellt, dass alle ausgewählten Leiterplattentestpunkte getestet worden sind, so bedeutet dies, dass alle Kalibrierdaten ermittelt worden sind. Das Verfahren zum Anfahren der ausgewählten Leiterplattentestpunkte kann somit abgeschlossen werden (S6). Danach werden die weiteren Leiterplattentestpunkte bzw. weitere Leiterplatten der Charge in der herkömmlichen Art und Weise geprüft.

Bei dem erfindungsgemäßen Verfahren werden die einzelnen Leiterplattentestpunkte automatisch angefahren, wobei anhand des erfassten Bildes, das die Prüfspitze und den zu kontaktierenden Leiterplattentestpunkt beinhaltet, der Abstand der Prüfspitze vom Zentrum des Leiterplattentestpunktes automatisch ermittelt und eine entsprechende Korrekturbewegung selbsttätig ausgeführt wird. Hierdurch werden Leiterplattentestpunkte korrekt kontaktiert, selbst wenn die Positionsdaten nicht exakt kalibriert sein sollten oder es Abweichungen in der Position der Leiterplattentestpunkte bezüglich ihrer Ideal-Position gibt. Somit wird die Zuverlässigkeit beim Kontaktieren eines Leiterplattentestpunktes mit dem erfindungsgemäßen Verfahren deutlich gesteigert.

Die Steuereinrichtung der Prüfvorrichtung ist derart ausgebildet, dass durch Eingabe bestimmter Eingabekoordinaten die Prüfsonde an eine bestimmte Stelle bewegt wird. Mit dem erfindungsgemäßen Verfahren werden diese Eingabekoordinaten mit den tatsächlichen Positionen der ausgewählten Leiterplattentestpunkte in Verbindung gebracht und daraus die Kalibrierdaten berechnet. Hierdurch wird in einem Schritt sowohl die Prüfvorrichtung an sich kalibriert als auch mit den CAD-Daten der zu untersuchenden Leiterplatte in Verbindung gebracht. Es werden somit die beiden eingangs erläuterten Kalibriervorgänge durch einen einzigen Kalibriervorgang ersetzt, der zudem beim Testen der Leiterplatte selbst ausgeführt wird. Das erfindungsgemäße Verfahren zum Anfahren eines ausgewählten Leiterplattentestpunktes dauert lediglich eine halbe bis zwei Sekunden länger als das Anfahren mit einer bereits kalibrierten Vorrichtung, so dass der gesamte Testvorgang im Vergleich zum Testen der kalibrierten Vorrichtung je nach Anzahl der ausgewählten Leiterplattentestpunkte um etwa eine halbe Minute bis drei Minuten verzögert wird. Dies stellt eine wesentliche Beschleunigung beim Testen mit Fingertestern gegenüber herkömmlichen Verfahren dar, bei welchen die Prüfvorrichtung zunächst kalibriert werden muss, bevor der eigentliche Testvorgang beginnt.

Bei dem oben anhand der Figur 5 und 6 beschriebenen Verfahren werden jeweils drei Bilder zum Anfahren eines Leiterplattentestpunktes 36 aufgenommen und ausgewertet. Im Rahmen der Erfindung ist es jedoch möglich, lediglich ein einziges Bild aufzunehmen und dann sofort den Leiterplattentestpunkt 36 korrekt anzufahren, wenn die Auflösung der Kamera ausreichend hoch ist. Sollten die Abweichungen jedoch größer sein oder die Auflösung der optischen Detektionseinrichtung geringer sein, so kann es auch zweckmäßig sein, mehrere Bilder aufzunehmen und entsprechend viele Korrekturschritte vorzunehmen. Das Aufnehmen eines Bildes mittels des Kamerachips dauert etwa 30 Millisekunden. Dies zeigt, dass das Aufnehmen des Bildes das gesamte Verfahren nur geringfügig verzögert.

Im Rahmen der vorliegenden Erfindung kann es auch zweckmäßig sein, dass die Prüfvorrichtung anhand einer ersten Leiterplatte einer Charge mit einer Anzahl von beispielsweise zehn bis 100 ausgewählten Leiterplattentestpunkten kalibriert wird und bei den weiteren zu testenden Leiterplatten lediglich zwei bis zehn ausgewählte Leiterplattentestpunkte entsprechend dem erfindungsgemäßen Verfahren angefahren werden, so dass hierdurch die Lage einer jeden zu testenden Leiterplatte in der Prüfvorrichtung überprüft wird. Beim Kalibrieren mittels zehn bis 100 Leiterplattentestpunkten werden Versätze, Verzüge und/oder Verzerrungen in der Anordnung der Leiterplattentestpunkte ermittelt. Derartige Versätze, Verzüge und/oder Verzerrungen in der Anordnung der Leiterplattentestpunkte sind in der internationalen Patentanmeldung WO 02/21893 A2 ausführlich beschrieben, weshalb die WO 02/21893 A2 in die vorliegende Patentanmeldung unter Bezugnahme inkorporiert wird. Es kann zweckmäßig sein, die Anzahl der beim Kalibriervorgang zu berücksichtigenden Leiterplattentestpunkte schrittweise zwischen dem Testen einer jeden Leiterplatte um z.B. jeweils fünf bis 20 Leiterplattentestpunkte zu vermindern. Sollte beim Testen einer Leiterplatte ein Fehlkontakt zwischen einem Prüffinger und einem Leiterplattentestpunkt auftreten, kann die Anzahl der beim Kalibrieren zu berücksichtigenden Leiterplattentestpunkte wieder erhöht werden. Nach einem Fehlkontakt ist es sogar zweckmäßig auf die maximale Anzahl der beim Kalibrieren zu berücksichtigenden Leiterplattentestpunkte zurück zu gehen.

Die minimale Anzahl der zu berücksichtigenden Leiterplattentestpunkte ist zwei für jede Seite der Leiterplatte, da mit zwei Punkten die Anordnung der Leiterplattentestpunkte in der Prüfebene exakt festgelegt ist. Will man die Lage der Leiterplatte im dreidimensionalen Raum exakt festlegen, so sind wenigstens drei Leiterplattentestpunkte beim Kalibrieren zu berücksichtigen. Es kann jedoch auch zweckmäßig sein, jede Leiterplatte anhand zumindest vier bis zehn Leiterplattentestpunkten zu kalibrieren.

Die Verwendung von Prüfsonden mit integrierter optischer Empfangseinrichtung benötigt keine zusätzliche Mechanik zum Verfahren einer Kamera, wie es bei herkömmlichen Fingertestern der Fall ist, die mittels einer Kamera die Prüfvorrichtung kalibrieren.

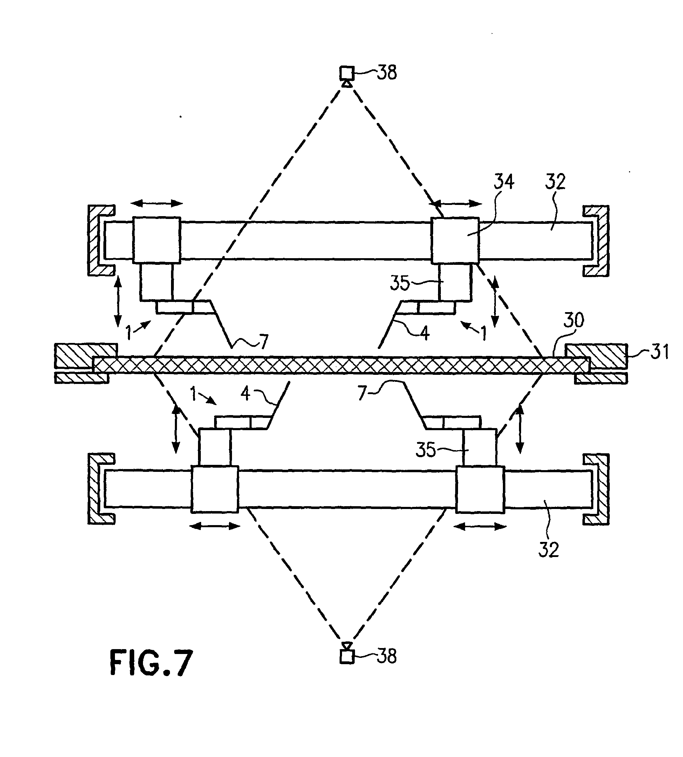

Bei den oben beschriebenen Vorrichtungen ist jeweils die optische Empfangseinrichtung an der Prüfsonde 1 angeordnet. Figur 7 zeigt eine Ausführungsform, bei der für jede Seite des Aufnahmebereiches jeweils eine Kamera 38 vorgesehen ist, die ortsfest im Bereich außerhalb der Traversen 32 angeordnet ist. Mit jeder Kamera 36 können die Kontaktspitzen 7 der Prüfsonden 1 erfasst werden. Dieser Aufbau ist mechanisch wesentlich einfacher als die oben beschriebenen Vorrichtungen. Er benötigt jedoch eine sehr hochauflösende Kamera mit einem guten Objektiv, damit der Ort der Kontaktspitze 7 mit der notwendigen Genauigkeit von zum Beispiel 0,05 mm erfasst werden kann. Zudem müssen die ausgewählten Leiterplattentestpunkte so gewählt werden, das beim Anfahren desselben die Kontaktspitze nicht durch eine Traverse oder anderes Teil der Prüfvorrichtung gegenüber der Kamera 38 verdeckt ist. Ansonsten kann das erfindungsgemäße Verfahren in der gleichen Weise wie oben beschrieben durchgeführt werden.

### Bezugszeichenliste

- 1: Prüfsonde
- 2: optische Empfangseinrichtung
- 3: optische Detektionseinrichtung
- 4: Prüfnadel
- 5: Nadel
- 6: Abschirmung
- 7: Kontaktspitze
- 8: Haltearm
- 9: Haltearm
- 10: Haltearm
- 11: Haltearm
- 12: Halterung
- 13a - 13h: Kontaktflächen
- 14: Leiterbahn
- 15: Schlitz
- 16: Bohrung
- 17: Wandung
- 18: Lichtschrankenelement
- 19: Messfahne
- 20: Messkante
- 21: Kamerachip
- 22: Haltearm
- 23: Haltearm
- 24: Lötstelle
- 25: Betrachtungskegel
- 26: Lichtwellenleiterkabel
- 27: freies Ende
- 28: Lichtleitfaser
- 29: Vorrichtung
- 30: Leiterplatte
- 31: Halterahmen
- 32: Traverse
- 33: Schiene
- 34: Schlitten
- 35: Prüfkopf
- 36: Leiterplattentestpunkt
- 37: Lot
- 38: Kamera
- 39: Steuereinrichtung
- 40: Detektions-/Auswerteeinrichtung

## Patentansprüche

1. Vorrichtung zum Prüfen von Leiterplatten, mit
- einem Aufnahmebereich zum Aufnehmen einer zu prüfenden Leiterplatte (30),
- Prüffingern (1) zum seriellen Kontaktieren von Leiterplattentestpunkten (36) einer zu prüfenden Leiterplatte (30) mittels jeweils einer Kontaktspitze (7), wobei die Prüffinger mittels einer Bewegungseinrichtung (32, 34, 35) entlang der Oberfläche einer zu prüfenden Leiterplatte verfahrbar und mit ihrer Kontaktspitze auf die Leiterplatte (30) absenkbar sind, **gekennzeichnet durch**
- eine optische Detektionseinrichtung (2, 21, 26, 38) zum optischen Detektieren von zumindest einer der Kontaktspitzen (7) der Prüffinger,
- eine Auswerteeinrichtung zum Erfassen eines Bildes der Kontaktspitze und zum Ermitteln des Abstandes der Prüfspitze (7) zum Zentrum eines zu kontaktierenden Leiterplattentestpunktes (36), und
- eine Steuereinrichtung zum Steuern der Bewegung der Prüfspitze (7) nach Maßgabe des von der Auswerteeinrichtung ermittelten Abstandes der Prüfspitze (7) zu einem zu testenden Leiterplattentestpunkt (36).

2. Vorrichtung nach Anspruch 1,
**gekennzeichnet durch**
eine Einrichtung zum Bewegen der Kontaktspitze (7) etwa senkrecht zur Oberfläche einer zu prüfenden Leiterplatte (30).

3. Vorrichtung nach Anspruch 2,
**dadurch gekennzeichnet,**
**dass** die Einrichtung zum Bewegen der Kontaktspitze (7) etwa senkrecht zur Oberfläche einer zu prüfenden Leiterplatte (30) einen Linearmotor aufweist.

4. Vorrichtung nach einem der Ansprüche 1 bis 3,
**gekennzeichnet durch**
Traversen (32), die den Aufnahmebereich überspannen und an welchen jeweils zumindest ein Schlitten (34)verfahrbar angeordnet ist und an jedem Schlitten (34) zumindest ein Prüffinger (1) angeordnet ist.

5. Vorrichtung nach Anspruch 4,
**dadurch gekennzeichnet,**
**dass** die Traversen (32) quer zu ihrer Längserstreckung verfahrbar und/oder die Prüffinger (1) quer zur Längserstreckung der Traversen (32) beweglich ausgebildet sind.

6. Vorrichtung nach einem der Ansprüche 1 bis 5,
**dadurch gekennzeichnet,**
**dass** die Kontaktspitzen (7) der Prüffinger jeweils an einer Prüfsonde (1) ausgebildet sind, und zumindest eine der Prüfsonden (1) mit einer Empfangseinrichtung (2) der optischen Detektionseinrichtung (3) versehen ist.

7. Vorrichtung nach Anspruch 6,
**dadurch gekennzeichnet,**
**dass** die Empfangseinrichtung ein Kamerachip (21) ist.

8. Vorrichtung nach Anspruch 6,
**dadurch gekennzeichnet,**
**dass** die Empfangseinrichtung ein Lichtwellenleiterkabel (26) ist.

9. Vorrichtung nach einem der Ansprüche 1 bis 5,
**dadurch gekennzeichnet,**
**dass** die optische Detektionseinrichtung (3) ortsfest angeordnet und zum optischen Erfassen zumindest einer der Prüfspitzen (7) ausgebildet ist.

10. Vorrichtung nach einem der Ansprüche 1 bis 9,
**dadurch gekennzeichnet,**
**dass** die optische Detektionseinrichtung (3) eine Kamera aufweist.

11. Verfahren zum Prüfen von Leiterplatten mit einer Vorrichtung zum Prüfen von Leiterplatten, umfassend
- einen Aufnahmebereich zum Aufnehmen einer zu prüfenden Leiterplatte,
- Prüffingern zum seriellen Kontaktieren von Leiterplattentestpunkten einer zu prüfenden Leiterplatte mittels jeweils einer Kontaktspitze, wobei die Prüffinger mittels einer Bewegungseinrichtung entlang der Oberfläche einer zu prüfenden Leiterplatte verfahrbar und mit ihrer Kontaktspitze auf die Leiterplatte aufsetzbar sind,
- einer optischen Detektionseinrichtung zum optischen Erfassen der Position von zumindest einer der Kontaktspitzen der Prüffinger,
wobei das Verfahren folgende Schritte zum Anfahren ausgewählter Leiterplattentestpunkte mit einer Kontaktspitze umfasst,
- Ausführen einer Positionierbewegung einer der Kontaktspitzen, die mit Abstand zur Oberfläche einer zu prüfenden Leiterplatte angeordnet ist, wobei die Kontaktspitze parallel zur Oberfläche der Leiterplatte verfahren wird, bis die Kontaktspitze etwa an einem auf einem im Zentrum eines Leiterplattentestpunktes senkrecht stehenden Lot positioniert ist, **gekennzeichnet durch** das
- Bewegen der Kontaktspitze senkrecht zur Oberfläche der zu prüfenden Leiterplatte auf diese zu, wobei mittels der optischen Detektionseinrichtung zumindest einmal die Position der Prüfspitze bzgl. des zu kontaktierenden Leiterplattentestpunktes erfasst wird und die Bewegungseinrichtung zum Ausführen einer parallel zur Oberfläche der zu prüfenden Leiterplatte gerichteten Korrekturbewegung derart angesteuert wird, dass die Kontaktspitze zu dem Lot hin bewegt wird.

12. Verfahren nach Anspruch 11,
**dadurch gekennzeichnet,**
**dass** Kalibrierdaten aus der Richtung und des Betrages der Korrekturbewegung ermittelt werden, die bei späteren Positionierbewegungen berücksichtigt werden.

13. Verfahren nach Anspruch 11 oder 12,
**dadurch gekennzeichnet,**
**dass** die Korrekturbewegung zum Korrigieren der Position einer Kontaktspitze mit mehreren Bewegungsschritten ausgeführt wird, wobei zwischen den einzelnen Bewegungsschritten jeweils die Position der Prüfspitze bzgl. des zu kontaktierenden Leiterplattentestpunktes erfasst wird.

14. Verfahren nach Anspruch 12 oder 13,
**dadurch gekennzeichnet,**
**dass** für eine jede Charge von zu prüfenden Leiterplatten bei der ersten der Charge zu prüfenden Leiterplatte die Kalibrierdaten anhand von zehn bis 100 Leiterplattentestpunkte ermittelt werden, wobei diese Kalibrierdaten zum Prüfen der weiteren Leiterplatten der Charge verwendet werden.

15. Verfahren nach Anspruch 14,
**dadurch gekennzeichnet,**
**dass** beim Testen der weiteren Leiterplatten der Charge Kalibrierdaten anhand von einer Anzahl Leiterplattentestpunkte ermittelt werden, die schrittweise zwischen dem Testen einer jeden Leiterplatte vermindert wird.

16. Verfahren nach Anspruch 14,
**dadurch gekennzeichnet,**
**dass** beim Testen der weiteren Leiterplatten der Charge Kalibrierdaten anhand von zwei bis zehn Leiterplattentestpunkten ermittelt werden.

17. Verfahren nach Anspruch 15 oder 16,
**dadurch gekennzeichnet,**
**dass** beim Testen der weiteren Leiterplatten einer Charge die Kalibrierdaten anhand von einer erhöhten Anzahl Leiterplattentestpunkte ermittelt werden, wenn ein Fehler beim Kontaktieren eines Prüffingers mit einem Leiterplattentestpunkt auftritt.

18. Verfahren nach einem der Ansprüche 11 bis 17,
**dadurch gekennzeichnet,**
**dass** eine Vorrichtung gemäß den Ansprüchen 1 bis 10 verwendet wird.

19. Prüfsonde für einen Fingertester,
wobei die Prüfsonde an einem Prüfkopf (35) anordbar ist, welcher zum Kontaktieren von Leiterplattentestpunkten in Richtung zu einer zu testenden Leiterplatte beweglich ist, mit
einer Kontaktspitze zum Kontaktieren eines Leiterplattentestpunktes,
**dadurch gekennzeichnet,**
**dass** die Prüfsonde (1) eine optische Detektionseinrichtung (2) aufweist, mit welcher die Kontaktspitze (7) optisch erfassbar ist.

20. Prüfsonde nach Anspruch 19,
**dadurch gekennzeichnet,**
**dass** die Empfangseinrichtung ein Kamerachip (21) ist.

21. Prüfsonde nach Anspruch 19,
**dadurch gekennzeichnet,**
**dass** die Empfangseinrichtung ein Lichtwellenleiterkabel (26) ist.

## Claims

1. Apparatus for the testing of circuit boards, having
- a mounting area for holding a circuit board (30) to be tested,
- test fingers (1) for the serial contacting of circuit board test points (36) of a circuit board (30) to be tested by means of a contact tip (7), wherein the test finger may be moved along the surface of a circuit board to be tested by means of a movement device (32, 34, 35) and can be lowered with its contact tip on to the circuit board (30),
**characterised by**
- an optical detection device (2, 21, 26, 38) for the optical detection of at least one of the contact tips (7) of the test fingers,
- an analysis unit to record an image of the contact tip and to determine the distance of the probe tip (7) from the centre of a circuit board test point (36) to be contacted, and
- a control unit to control the movement of the probe tip (7) on the basis of the distance of the probe tip (7) from a circuit board test point (36) to be tested, as determined by the analysis unit.

2. Apparatus according to claim 1,
**characterised by**
a device for moving the contact tip (7) approximately at right-angles to the surface of a circuit board (30) to be tested.

3. Apparatus according to claim 2,
**characterised in that**
the device for moving the contact tip (7) approximately at right-angles to the surface of a circuit board (30) has a linear motor.

4. Apparatus according to any of claims 1 to 3,
**characterised by**
cross-bars (32) which span the mounting area and on which in each case at least one slide (34) is movably mounted and on each slide (34) at least one test finger (1) is mounted.

5. Apparatus according to claim 4,
**characterised in that**
the cross-bars (32) may be moved at right-angles to their longitudinal extent and/or the test fingers (1) are designed to move at right-angles to the longitudinal extent of the cross-bars (32).

6. Apparatus according to any of claims 1 to 5,
**characterised in that**
the contact tips (7) of the test fingers are in each case formed on a test probe (1), and at least one of the test probes (1) is provided with a receiver device (2) of the optical detection device (3).

7. Apparatus according to claim 6,
**characterised in that**
the receiver device is a camera chip (21).

8. Apparatus according to claim 6,
**characterised in that**
the receiver device is an optical fibre cable (26).

9. Apparatus according to any of claims 1 to 5,
**characterised in that**
the optical detection device (3) is stationary and is designed for optical detection of one or more of the probe tips (7).

10. Apparatus according to any of claims 1 to 9,
**characterised in that**
the optical detection device (3) has a camera.

11. Method for the testing of circuit boards with an apparatus for the testing of circuit boards, comprising
- a mounting area for holding a circuit board to be tested,
- test fingers for the serial contacting of circuit board test points of a circuit board to be tested by means of a contact tip, wherein the test finger may be moved along the surface of a circuit board to be tested by means of a movement device and can be placed by its contact tip on to the circuit board,
- an optical detection device for the optical detection of the position of at least one of the contact tips of the test finger,
wherein the method comprises the following steps for approaching selected circuit board test points with a contact tip,
- execution of a positioning movement of one of the contact tips, which is arranged at a distance from the surface of a circuit board to be tested, wherein the contact tip is moved parallel to the surface of the circuit board until the contact tip is positioned approximately on a solder standing vertically in the centre of a circuit board test point,
**characterised in that**
- the movement of the contact tip at right-angles to the surface of the circuit board to be tested wherein by means of the optical detection device the position of the probe tip relative to the circuit board test point to be contacted is detected at least once, and the movement device for executing a correction movement directed parallel to the surface of the circuit board to be tested is driven in such a way that the contact tip is moved towards the solder.

12. Method according to claim 11,
**characterised in that**
from the direction and amount of the correction movement, calibration data are determined for use in subsequent positioning movements.

13. Method according to claim 11 or 12,
**characterised in that**
the correction movement for correcting the position of a contact tip is executed in several movement steps wherein, between the individual movement steps, the position of the probe tip relative to the circuit board test point to be contacted is detected in each case.

14. Method according to claim 12 or 13
**characterised in that**,
for each batch of circuit boards to be tested, the calibration data for the first circuit board of the batch to be tested are determined with the aid of ten to 100 circuit board test points, with this calibration data being used for the testing of further circuit boards of the batch.

15. Method according to claim 14
**characterised in that**,
in the testing of further circuit boards of the batch, calibration data are determined with the aid of a number of circuit board test points which is reduced in steps between the testing of each circuit board.

16. Method according to claim 14,
**characterised in that**
in the testing of further circuit boards of the batch, calibration data are determined with the aid of two to ten circuit board test points.

17. Method according to claim 15 or 16,
**characterised in that**
in the testing of further circuit boards of the batch, calibration data are determined with the aid of an increased number of circuit board test points if a fault occurs in the contacting of a circuit board test point by a test finger.

18. Method according to any of claims 11 to 17,
**characterised in that**
an apparatus according to claims 1 to 10 is used.

19. Test probe for a finger tester,
wherein the test probe may be mounted on a test head (35) which can be moved towards a circuit board to be tested for the contacting of circuit board test points, with a contact tip for the contacting of a circuit board test point,
**characterised in that**
the test probe (1) has an optical detection device (2) by means of which the contact tip (7) may be optically detected.

20. Test probe according to claim 19,
**characterised in that**
the receiver device is a camera chip (21).

21. Test probe according to claim 19,
**characterised in that**
the receiver device is an optical fibre cable (26).

## Revendications

1. Dispositif pour tester des cartes à circuits imprimés, comprenant :
-- une zone de réception pour recevoir une carte à circuits imprimés à tester (30),
-- des doigts de test (1) pour établir en série des contacts avec des points de test de la carte à circuits imprimés (36) d'une carte à circuits imprimés (30) à tester au moyen d'une pointe de contact respective (7), lesdits doigts de test pouvant être déplacés le long de la surface d'une carte à circuits imprimés à tester au moyen d'un dispositif de déplacement (32, 34, 35) et pouvant être abaissés avec leurs pointes de contact vers la carte à circuits imprimés (30),
**caractérisé par** :
-- un dispositif de détection optique (2, 21, 26, 38) pour la détection optique de l'une au moins des pointes de contact (7) des doigts de test,
-- un système d'évaluation pour capter une image de la pointe de contact et pour déterminer la distance de la pointe de contact (7) au centre d'un point de test (36) de la carte à circuits imprimés avec lequel il s'agit d'établir un contact, et
-- un dispositif de commande pour commander le déplacement de la pointe de test (7) en fonction de la mesure de la distance déterminée par le système d'évaluation entre la pointe de test (7) et l'un des points de test (36) de la carte à circuits imprimés qu'il s'agit de tester.

2. Dispositif selon la revendication 1,
**caractérisé par** un système pour déplacer la pointe de contact (7) approximativement perpendiculairement à la surface d'une les cartes à circuits imprimés (30) qu'il s'agit de tester.

3. Dispositif selon la revendication 2,
**caractérisé en ce que** le dispositif pour déplacer la pointe de contact (7) approximativement perpendiculairement à la surface d'une carte à circuits imprimés (30) à tester comprend un moteur linéaire.

4. Dispositif selon l'une des revendications 1 à 3,
**caractérisé par** des traverses (32), qui surplombent la zone de réception, et sur lesquelles au moins un chariot (34) respectif est agencé avec possibilité de translation, et en ce qu'au moins un doigt de test (1) est agencé sur chaque chariot (34).

5. Dispositif selon la revendication 4,
**caractérisé en ce que** les traverses (32) sont déplaçables perpendiculairement à leur extension longitudinale, et/ou les doigts de tests (1) sont réalisés mobiles transversalement à l'extension longitudinale des traverses (32).

6. Dispositif selon l'une des revendications 1 à 5,
**caractérisé en ce que** les pointes de contact (7) des doigts de tests sont réalisées chacune sur une sonde de test (1), et **en ce que** l'une au moins des sondes de test (1) est pourvue d'un dispositif de réception (2) du système de détection optique (3).

7. Dispositif selon la revendication 6,
**caractérisé en ce que** le système de réception est une puce de caméra (21).

8. Dispositif selon la revendication 6,
**caractérisé en ce que** le système de réception est un câble guide d'ondes lumineuses (26).

9. Dispositif selon l'une des revendications 1 à 5,
**caractérisé en ce que** le dispositif de détection optique (3) est agencé stationnaire, et **en ce qu'**il est réalisé pour la détection optique de l'une au moins des pointes de test (7).

10. Dispositif selon l'une des revendications 1 à 9,
**caractérisé en ce que** le dispositif de détection optique (3) comprend une caméra.

11. Procédé pour tester des cartes à circuits imprimés avec un dispositif destiné à tester des cartes à circuits imprimés, comprenant :
-- une zone de réception pour recevoir une carte à circuits imprimés à tester,
-- des doigts de test pour établir en série des contacts avec des points de test d'une carte à circuits imprimés à tester au moyen d'une pointe de contact respective, lesdits doigts de test pouvant être déplacés le long de la surface d'une carte à circuits imprimés à tester au moyen d'un dispositif de déplacement et pouvant être posés avec leurs pointes de contact vers la carte à circuits imprimés,
-- un dispositif de détection optique pour la détection optique de l'une au moins des pointes de contact des doigts de test, le procédé comprenant les étapes suivantes pour l'approche de points de test choisis sur la carte à circuits imprimés au moyen d'une pointe de contact :
-- exécution d'un mouvement de positionnement de l'une des pointes de contact, laquelle est agencée à distance par rapport à la surface d'une carte à circuits imprimés à tester, ladite pointe de contact étant déplacée parallèlement à la surface de la carte à circuits imprimés jusqu'à ce que la pointe de contact soit positionnée approximativement sur une verticale dressée au centre d'un point de test de la carte à circuits imprimés, **caractérisé par** :
-- le déplacement de la pointe de contact perpendiculairement à la surface de la carte à circuits imprimés à tester, en rapprochement de celle-ci, et dans lequel au moyen du dispositif de détection optique, on détecte au moins une fois la position de la pointe de contact par rapport au point de test de la carte à circuits imprimés qu'il s'agit de contacter, et pour exécuter un mouvement de correction dirigé parallèlement à la surface de la carte à circuits imprimés à tester, le dispositif de déplacement est piloté de telle manière que les pointes de contact sont déplacées vers la verticale.

12. Procédé selon la revendication 11,
**caractérisé en ce que** des données de calibrage sont déterminées à partir de la direction et de l'ampleur du mouvement de correction, qui sont prises en compte de lors de mouvements de positionnement ultérieurs.

13. Procédé selon la revendication 11 ou 12,
**caractérisé en ce que** le mouvement de correction pour corriger la position d'une pointe de contact est exécuté en plusieurs pas de déplacement, de sorte que la position respective de la pointe de test par rapport au point de test de la carte à circuits imprimés qu'il s'agit de contacter est déterminée entre les pas de déplacement individuels.

14. Procédé selon la revendication 12 ou 13,
**caractérisé en ce que** pour chaque lot de cartes à circuits imprimés à tester, on détermine les données de calibrage pour les premières cartes à circuits imprimés du lot à tester, à l'aide de 10 à 100 points de test, et ces données de calibrage sont utilisées pour tester les autres cartes à circuits imprimés du lot.

15. Procédé selon la revendication 14,
**caractérisé en ce que** lors du test des autres cartes à circuits imprimés du lot, on détermine des données de calibrage à l'aide d'un certain nombre de points de test, ce nombre étant réduit progressivement entre le test de chaque carte à circuits imprimés.

16. Procédé selon la revendication 14,
**caractérisé en ce que** lors du test des autres cartes à circuits imprimés du lot, on détermine des données de calibrage à l'aide de deux à dix points de test.

17. Procédé selon la revendication 15 ou 16,
**caractérisé en ce que** lors du test des autres cartes à circuits imprimés du lot, les données de calibrage sont déterminées à l'aide d'un nombre augmenté de points de test s'il se produit une erreur lors de la mise en contact d'un doigt de test avec un point de test sur la carte à circuits imprimés.

18. Procédé selon l'une des revendications 11 à 17,
**caractérisé en ce que** l'on utilise un dispositif selon les revendications 1 à 10.

19. Sonde de test pour un dispositif de test à doigts,
dans lequel la sonde de test est susceptible d'être agencée sur une tête de test (35) qui, pour la mise en contact de points de test, est déplaçable en direction d'une carte à circuits imprimés à tester, et comprend une pointe de contact pour la mise en contact d'un point de test de la carte à circuits imprimés,
**caractérisée en ce que** la sonde de test (1) comprend un dispositif de détection optique (2) au moyen duquel la pointe de contact (7) peut être détectée de manière optique.

20. Sonde de test selon la revendication 19,
**caractérisée en ce que** le dispositif récepteur est une puce de caméra (21).

21. Sonde de test selon la revendication 19,
**caractérisée en ce que** le dispositif récepteur est un câble guide d'ondes de lumière (26).
